## Europäisches Patentamt

## European Patent Office

## Office européen des brevets

(11) Veröffentlichungsnummer: **0 093 285**
**B1**

(12) **EUROPÄISCHE PATENTSCHRIFT**

(45) Veröffentlichungstag der Patentschrift:
14.08.85

(51) Int. Cl.⁴: **G 01 R 15/08, H 03 K 17/62**

(21) Anmeldenummer: 83103526.6

(22) Anmeldetag: 12.04.83

(54) **Durchschaltung mehrerer Spannungs- oder Stromquellen an eine gemeinsame Messeinrichtung.**

(30) Priorität: 29.04.82 DE 3216020

(43) Veröffentlichungstag der Anmeldung:
09.11.83 Patentblatt 83/45

(45) Bekanntmachung des Hinweises auf die Patenterteilung:
14.08.85 Patentblatt 85/33

(84) Benannte Vertragsstaaten:
AT BE CH FR GB IT LI NL SE

(56) Entgegenhaltungen:
DE - B - 2 203 306
DE - B - 2 927 264

IBM TECHNICAL DISCLOSURE BULLETIN, Band 22, Nr. 8B, Januar 1980, A.J. BUTLER et al. "High-speed switchable voltage-controlled current/voltage source", Seiten 3597-3598
RADIO FERNSEHEN ELEKTRONIK, Band 23, Nr. 19, 1974, W. STEFFEN "Elektronischer Mestellenumschalter mit MOS-Bauelementen", Seiten 640-643

(73) Patentinhaber: Siemens Aktiengesellschaft, Berlin und München Wittelsbacherplatz 2, D-8000 München 2 (DE)

(72) Erfinder: Töpfer, Friedrich, Dipl.-Ing., Schlossstrasse 6, D-6735 Maikammer (DE)

ACTORUM AG

## Beschreibung

Die Erfindung bezieht sich auf eine Vorrichtung zur Herstellung der Schaltverbindungen von mehreren Spannungs- oder Stromquellen mit sperrstrombehafteten Schaltern zu einer gemeinsamen Messeinrichtung, wobei jeder Verbindungsweg über zwei in Serie liegende Schalter führt und dritte Schalter vorgesehen sind, welche die Verbindungspunkte der in Serie liegenden, gesperrten Schalter an ein vorgegebenes Potential anschliessen.

In der Messtechnik besteht oft die Aufgabe, mehrere Spannungs- oder Stromquellen über Schalter mit einer Messeinrichtung zu verbinden. Auch stromdurchflossene Widerstände sind als Spannungsquellen anzusehen. Spannungsquellen mit grossem Innenwiderstand werden als Stromquellen betrachtet. Die zur Durchschaltung in der Praxis verwendeten Schalter weisen endliche Durchschalt- und Sperrwiderstände auf. Dies führt dazu, dass beispielsweise bei einer Messanordnung, mit der zwei Spannungsquellen über zwei Schalter mit einer Messeinrichtung abwechselnd verbunden werden können, über den Sperrwiderstand des Schalters für die derzeit nicht angeschlossene Spannungsquelle ein Sperrstrom über den Durchschaltwiderstand des geschlossenen Schalters in die derzeit an die Messeinrichtung angeschlossene Spannungsquelle fliesst.

Der Spannungsabfall über den Durchschaltwiderstand des geschlossenen Schalters und ein eventueller Spannungsabfall über den Innenwiderstand der an die Messeinrichtung angeschlossenen Quelle bewirken, dass die gemessene Spannung nicht der eigentlichen Ausgangsspannung der angeschlossenen Quelle entspricht. Sind nicht nur zwei, sondern n Quellen vorhanden, die über n Schalter an eine Messeinrichtung angeschlossen werden können, so addieren sich die Sperrströme der jeweils gesperrten Schalter zu einem Wert, der ungefähr das $(n-1)$-fache des Sperrstromes eines einzelnen Schalters ist. Bei vorgegebenen Fehlergrenzen ist damit der Ausbaugrad einer derartigen Schaltvorrichtung begrenzt.

Eine Lösung dieses Problems könnte in der Anordnung von jeweils zwei in Serie liegenden Schaltern pro anzuschliessende Quelle gesehen werden, wobei der Verbindungspunkt der beiden Schalter zur Ableitung des Sperrstromes des ersten der beiden Serienschalter über einen dritten Schalter an Nullpotential gelegt ist. Wie später an einer Figur gezeigt werden wird, ist bei dieser Schaltung jedoch die jeweils an die Messeinrichtung durchgeschaltete Quelle mit dem Sperrwiderstand des zweiten Serienschalters der nicht durchgeschalteten Quelle und dem Durchgangswiderstand des geschlossenen Ableitschalters für diese Quelle belastet.

In dem Buch «Operationsverstärker in Theorie und Praxis», H. Hahn, Verlag Erwin Geyer, Bad Wörishofen, Kaufdatum 1970, S. 68-71 ist unter 8.5 «Elektrometerverstärker» und anhand der Abbildung 43 auf S. 70 eine Schaltung eines Operationsverstärkers angegeben, bei dem ein Eingangssignal dem nichtinvertierenden Eingang des Verstärkers zugeführt und der Ausgang des Verstärkers mit dem invertierenden Eingang direkt verbunden ist. Diese Schaltung wird auch als Spannungsfolger oder Impedanzwandler bezeichnet.

In der Zeitschrift radio fernsehen elektronik, 1974, Heft 19, S. 640-643 ist ein elektronischer Messstellenumschalter mit MOS-Bauelementen beschrieben, in dem auch die störende Wirkung von Leckströmen zwischen dem vorgespannten Substrat und der Source-Elektrode der als Schalter verwendeten MOS-Transistoren erwähnt ist. Indem Aufsatz sind jedoch keine Massnahmen erwähnt, mit denen die Wirkung dieser Ströme unschädlich gemacht wird; es ist nur in Bild 4 eine Messschaltung für diese Ströme angegeben.

Aus der DE-B1-2203306 ist eine Schaltungsanordnung zur Nullpunktsverschiebung von Messspannungen bekannt, bei der im Zusammenwirken mit einem Messstellenwähler ein zeitweilig als Spannungsfolger geschalteter Operationsverstärker auftritt.

Der Erfindung lag die Aufgabe zugrunde, sowohl eine Verfälschung der Ausgangsspannung der jeweils an die Messeinrichtung angeschlossenen Quelle durch die Sperrströme der Schalter der nicht angeschlossenen Quellen als auch eine Belastung der angeschlossenen Quelle durch Sperrwiderstände der Schalter für nicht angeschlossene Quellen zu verhindern.

Eine Lösung dieser Aufgabe ergeben gemäss der Erfindung die kennzeichnenden Merkmale des Patentanspruchs 1. Es wird im eingehenderen Teil der Beschreibung gezeigt werden, dass der störende Einfluss des Sperrstromes der Schalter nicht an die Messeinrichtung angeschlossener Quellen um den Faktor $10^9$ vermindert wird.

Bei einer besonderen Ausführungsart der Erfindung sind den nachgeordneten Serienschaltern über mehrere eingangsseitig parallelliegende Schalter mehrere Quellen zugeordnet.

Die Erfindung wird anhand von fünf Figuren näher erläutert. Die Figuren sind schematische Schaltbilder.

Fig. 1 zeigt eine Schaltung, bei der das durch die Erfindung zu lösende Problem auftritt.

In Fig. 2 ist eine Schaltung gezeigt, bei welcher der Versuch, das gestellte Problem zu lösen, einen anderen Fehler hervorruft.

In Fig. 3 ist eine Schaltung nach der Erfindung gezeigt.

Fig. 4 stellt ein Ersatzschaltbild der Schaltung nach Fig. 3 dar.

Fig. 5 zeigt eine besondere Ausführungsart der Erfindung.

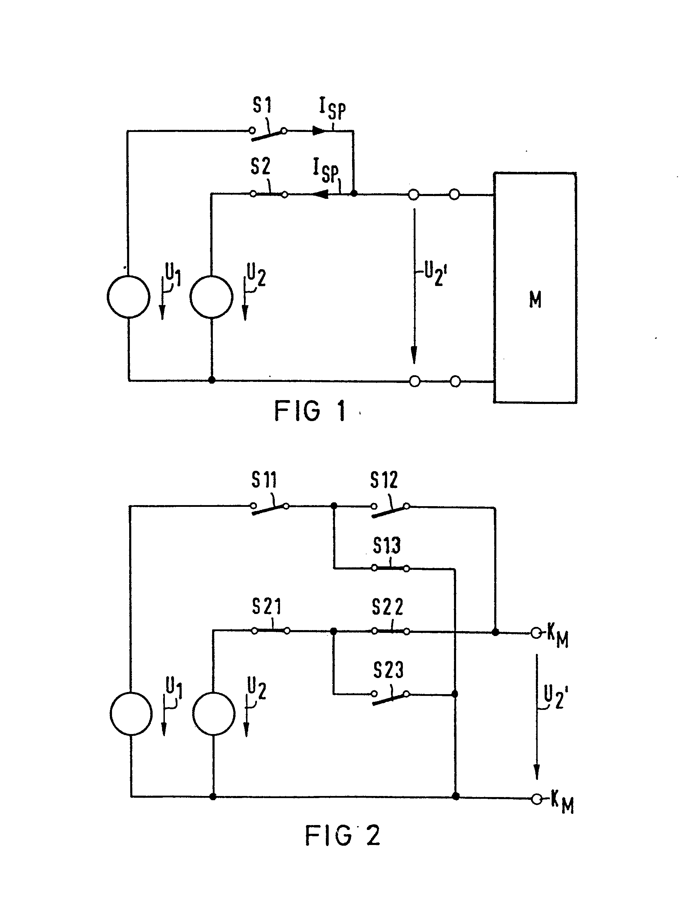

In der Fig. 1 sind zwei Quellen mit den Ausgangsspannungen $U_1$ bzw. $U_2$ über Schalter S1 und S2 wahlweise mit einer Messeinrichtung M verbindbar. Der Schalter S1 ist offen. Der Schalter S2 ist geschlossen; er legt also die Quelle mit der Spannung $U_2$ an die Messeinrichtung M. An den Eingangsklemmen der Messeinrichtung M liegt eine Spannung $U_2'$, die nicht mit $U_2$ übereinstimmen wird, wenn ein Sperrstrom $I_{SP}$ des gesperrten

Schalters S1 über den geschlossenen Schalter S2 und die Quelle mit der Ausgangsspannung $U_2$ fliesst.

Eine mögliche Lösung dieses Problems, die aber ein neues Problem aufwirft, wird in der Fig. 2 gezeigt. Dort sind Quellen mit der Spannung $U_1$ und $U_2$ über in Serie liegende Schalter S11 und S12 bzw. S21 und S22 wahlweise mit Eingangsklemmen $K_M$ einer nicht dargestellten Messeinrichtung verbindbar. Ableitschalter S13 bzw. S23 legen die Verbindungspunkte der in Serie liegenden Schalter an Nullpotential. Diese Ableitschalter werden so gesteuert, dass jeweils der Verbindungspunkt der geöffneten Serienschalter an Nullpotential liegt. Damit liegt aber über der Spannungsquelle mit der Ausgangsspannung $U_2$ die Serienschaltung des Sperrwiderstandes des Schalters S12 mit dem Durchgangswiderstand des geschlossenen Ableitschalters S13. Insbesondere, wenn mehrere nicht angeschlossene Spannungsquellen vorhanden sind, wird die jeweils angeschlossene Spannungsquelle unzulässig durch diese parallelliegenden Serienschaltungen eines Schaltersperrwiderstandes und eines Schalterdurchgangswiderstandes belastet.

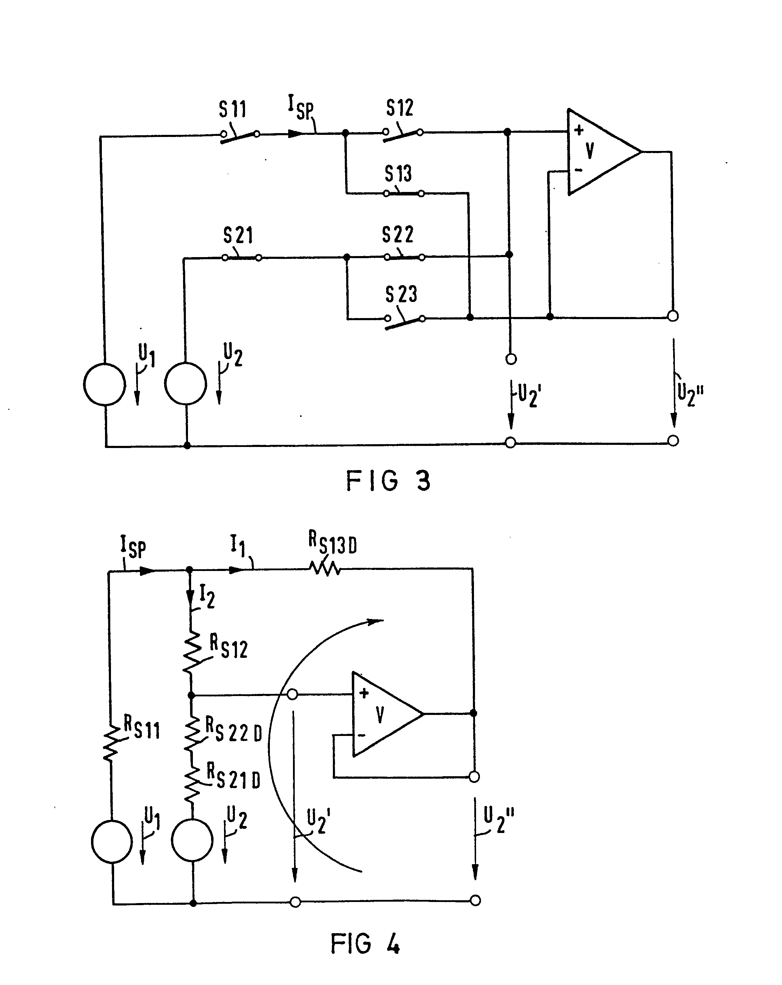

Die Fig. 3 zeigt eine Schaltung, die der Erfindung entspricht. Die messeinrichtungsseitigen Anschlüsse der nachgeschalteten Serienschalter S12 bzw. S22 liegen dabei an einem der Eingänge eines Verstärkers V, der als Spannungsfolger betrieben wird. Die ausgangsseitigen Anschlüsse der Ableitschalter S13 bzw. S23 sind an die Ausgangsklemme des Verstärkers V angeschlossen. Dabei ist der Ableitschalter S13, welcher der nicht angeschlossenen Spannungsquelle mit der Spannung $U_1$ zugeordnet ist, geschlossen und der Ableitschalter S23, der zu der angeschlossenen Quelle mit der Ausgangsspannung $U_2$ gehört, geöffnet. Weil der Verstärker V als Spannungsfolger betrieben wird, liegt an seiner Ausgangsklemme die gleiche Spannung wie an seiner mit der jeweils angeschlossenen Quelle verbundenen Eingangsklemme. Der Verbindungspunkt der beiden gesperrten Schalter S11 und S12 führt also die gleiche Spannung wie der ausgangsseitige Anschluss des Schalters S12. Damit kann über den Schalter S12 kein Sperrstrom getrieben werden. Ein eventuell über den gesperrten Schalter S11 fliessender Sperrstrom kann seinerseits wegen des offenen Schalters S23 die Quelle mit der Ausgangsspannung $U_2$ kaum beeinflussen. Die zwischen der einen Eingangsklemme des Verstärkers V und Nullpotential abzunehmende Messspannung $U_2'$ entspricht also weitgehend unverfälscht der von der angeschlossenen Quelle abgegebenen Spannung $U_2$.

Das Ersatzschaltbild der Schaltung nach Fig. 3 wird in Fig. 4 dargestellt. Die Sperr- bzw. Durchgangswiderstände der einzelnen Schalter sind durch Indizes, die die Schalterbezeichnung enthalten, gekennzeichnet. Geschlossene Schalter sind dabei durch einen zusätzlichen Index D als Durchgangswiderstand erkennbar. Am Verzweigungspunkt der Schalter S11, S12 und S13 gilt nach der Knotenregel:

$$I_{SP} - I_1 I_2 = 0 \qquad (1)$$

Für die rechte Seite des Ersatzschaltbildes gilt mit dem eingezeichneten Umlaufsinn nach der Maschenregel:

$$U_2'' - U_2 - I_2 (R_{S21D} + R_{S22D}) - I_2 R_{S12} + I_1 R_{S13D} = 0 \quad (2)$$

Weiter lässt sich für $U_2' = U_2''$ infolge der Spannungsfolgerwirkung des Verstärkers V eine dritte Gleichung ableiten:

$$U_2' = U_2'' = I_2 (R_{S22D} + R_{S21D}) + U_2 \qquad (3)$$

Wird Gleichung (3) in Gleichung (2) eingesetzt, so ergibt sich:

$$I_2 (R_{S22D} + R_{S21D}) + U_2 - U_2 - I_2 (R_{S21D} + R_{S22D}) \\ - I_2 R_{S12} + I_1 R_{S13D} = 0$$

daraus

$$I_1 R_{S13D} = I_2 R_{S12}$$

$$I_2 = I_1 \frac{R_{S13D}}{R_{S12}}$$

Gleichung (1) lässt sich umformen in:

$$I_1 = I_{SP} - I_2$$

Dies eingesetzt in die vorausgegangene Zeile ergibt:

$$I_2 = I_{SP} \frac{R_{S13D}}{R_{S12} + R_{S13D}}$$

Weil nun der Durchgangswiderstand $R_{S13D}$ sehr viel kleiner ist als der Sperrwiderstand $R_{S12}$, ist

$$I_2 \approx I_{SP} \frac{R_{S13D}}{R_{S12}}$$

Durch die Erfindung wird also der Einfluss des Sperrstromes $I_{SP}$ um den Faktor

$$\frac{R_{S13D}}{R_{S12}}$$

verkleinert. Bei praktischen Werten für diese Widerstände ergeben sich für

$$R_{S13D} = 10 \, \Omega$$

und

$$R_{S12} = 10^{10} \Omega$$

Damit wird der Faktor

$$\frac{R_{S13D}}{R_{S12}} = \frac{10}{10^{10}} = 10^{-9}$$

Der störende Einfluss des Sperrstromes $I_{SP}$ wird also um den Faktor $10^9$ vermindert.

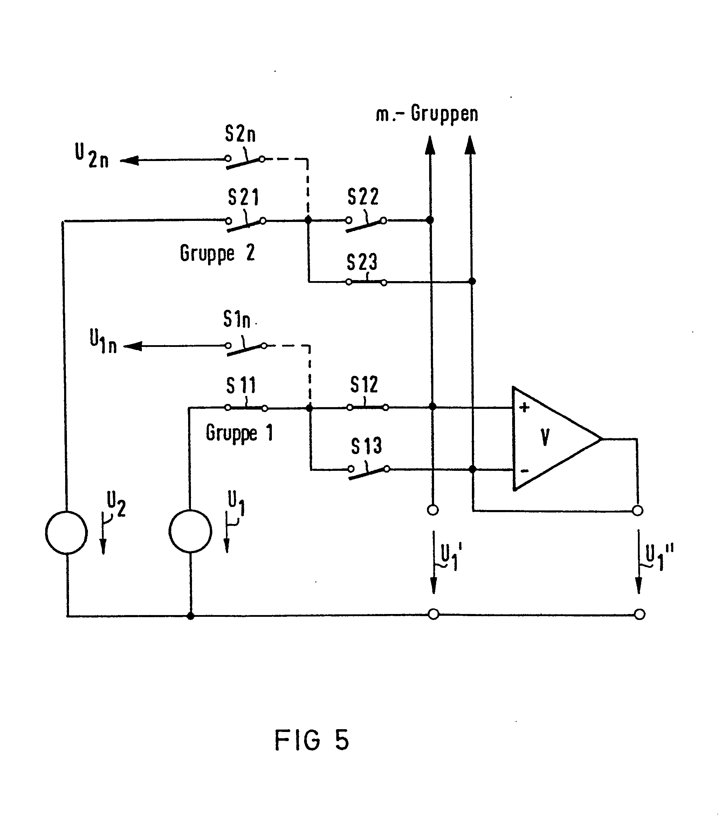

In der Fig. 5 ist eine Schaltung dargestellt, die im Prinzip der Schaltung nach Fig. 3 entspricht. Sie ist jedoch auf den besonderen Fall zugeschnitten, bei dem sich eine störende Wirkung erst bei einer Summierung von Sperrströmen einer bestimmten Anzahl gesperrter Schalter der jeweils nicht angeschlossenen Quellen einstellt. Hier kann eine kleinere Anzahl Quellen mit ersten Schaltern parallel zu Gruppen zusammengefasst werden und einer Gruppe jeweils ein in Serie dazu liegender zweiter Schalter sowie ein Ableitschalter zugeordnet sein.

In der Fig. 5 ist eine Quelle mit der Ausgangsspannung $U_1$ über zwei Serienschalter S11 und S12 an eine Eingangsklemme des Verstärkers V angeschlossen. An den Verbindungspunkt der Serienschalter S11 und S12 ist parallel über einen Schalter S1n eine Quelle mit der Spannung $U_{1n}$ anschliessbar. Der Index n deutet an, dass noch mehrere Quellen an den gleichen Verbindungspunkt angeschlossen werden können, bis zu einer Anzahl, für die die Sperrströme über die Schalter S1n noch unterhalb einer festgesetzten Fehlergrenze liegen. Über diese Anzahl hinausgehende Quellen sind über Schalter S2n und einen Schalter S21 zu einer zweiten Gruppe von Quellen zusammengefasst. Der Schalter S21 wird von einem Serienschalter S22 gefolgt. Am Verbindungspunkt der beiden Schalter liegt ein Ableitschalter S23, der geschlossen ist und den Verbindungspunkt der derzeit nicht angeschlossenen Gruppe von Quellen zugeordneten Serienschaltern S21 und S22 mit der Ausgangsklemme des Verstärkers V verbindet.

## Patentansprüche

1. Vorrichtung zur Herstellung der Schaltverbindungen von mehreren Spannungs- oder Stromquellen ($U_1$, $U_2$) mit sperrstrombehafteten Schaltern (S11, S21) zu einer gemeinsamen Messeinrichtung, wobei jeder Verbindungsweg über zwei in Serie liegende Schalter (S12, S22) führt und dritte Schalter (S13, S23) vorgesehen sind, welche die Verbindungspunkte der in Serie liegenden, gesperrten Schalter an ein vorgegebenes Potential anschliessen, dadurch gekennzeichnet, dass ausgangsseitige Anschlüsse der — vom Eingang her gesehen — nachgeordneten Serienschalter (S12, S22) mit dem nichtinvertierenden Eingang eines als Spannungsfolger (Impedanzwandler) betriebenen Verstärkers (V) verbunden sind, dass die Fusspunkte der dritten Schalter (S13, S23) an der Ausgangsklemme des Verstärkers (V) liegen und dass die Messeinrichtung zwischen dem nichtinvertierenden Eingang des Verstärkers (V) und einer Nullschiene angeschlossen ist.

2. Vorrichtung nach Anspruch 1, dadurch gekennzeichnet, dass den nachgeordneten Serienschaltern (S12, S22) über mehrere eingangsseitig parallelliegende Schalter (S11 ... S1n bzw. S21 ... S2n) mehrere Quellen ($U_1$ ... $U_{1n}$ bzw. $U_2$ ... $U_{2n}$) zugeordnet sind.

## Claims

1. A device for establishing the switching connections of a plurality of voltage or current sources ($U_1$, $U_2$) with switches (S11, S21), acted upon by blocking current to form a common measuring device, where each connection path leads across two switches (S12, S22) arranged in series, and third switches (S13, S23) are provided which connect the connection points of the blocked series switches to a predetermined potential, characterised in that output terminals of the series switches (S12, S22) next in sequence — viewed from the input — are connected to the non-inverting input of an amplifier (V) operated as a voltage follower (impedance transducer), that the bases of the third switches (S13, S23) are connected to the output terminal of the amplifier (V), and that the measuring device is connected between the non-inverting input of the amplifier (V) and a zero bus bar.

2. A device as claimed in Claim 1, characterised in that the series switches (S12, S22) which are next in line are assigned a plurality of sources ($U_1$ ... $U_{1n}$ and $U_2$ ... $U_{2n}$) via a plurality of switches (S11 ... S1n and S21 ... S2n) arranged in parallel at the input end.

## Revendications

1. Dispositif pour établir les connexions de couplage de plusieurs sources de tension ou de courant ($U_1$, $U_2$) comportant des interrupteurs (S11, S21) affectés d'une caractéristique de courant à l'état bloqué avec un appareil de mesure commun, chaque voie de liaison passant par deux interrupteurs (S12, S22) montés en série et des troisièmes interrupteurs (S13, S23) étant prévus pour raccorder les points de jonction des interrupteurs montés en série à un potentiel préfixé lorsqu'ils sont à l'état bloqué, caractérisé en ce que les bornes de sortie des interrupteurs série (S12, S22) prévus en aval — vus depuis l'entrée — sont reliées à l'entrée directe d'un amplificateur (V) monté en suiveur de tension (transformateur d'impédance), en ce que les points de base des troisièmes interrupteurs (S13, S23) sont reliés à la borne de sortie de l'amplificateur (V) et en ce que l'appareil de mesure est branché entre l'entrée directe de l'amplificateur (V) et un conducteur neutre.

2. Dispositif selon la revendication 1, caractérisé en ce que plusieurs sources ($U_1$ ... $U_{1n}$ respectivement $U_2$ ... $U_{2n}$) sont coordonnées, à travers plusieurs interrupteurs (S11 ... S1n respectivement S21 ... S2n) montés en parallèle côté entrée, aux interrupteurs série (S12, S22) prévus en aval.

FIG 1

FIG 2

FIG 3

FIG 4

FIG 5